**Europäisches Patentamt**

**European Patent Office**

**Office européen des brevets**

(19)

(11) Veröffentlichungsnummer: **0 235 320**
**A1**

(12) **EUROPÄISCHE PATENTANMELDUNG**

(21) Anmeldenummer: **86102591.4**

(22) Anmeldetag: **28.02.86**

(51) Int. Cl.⁴: **H05K 7/14 , H01R 9/26**

(43) Veröffentlichungstag der Anmeldung:
**09.09.87 Patentblatt 87/37**

(84) Benannte Vertragsstaaten:
**AT CH DE FR GB IT LI**

(71) Anmelder: **C.A. Weidmüller GmbH & Co.**
**Postfach 950 Paderborner Strasse 175**
**D-4930 Detmold 14(DE)**

(72) Erfinder: **Frikkee, Arian**
**Felsenweg 16a**
**D-4930 Detmold(DE)**

(74) Vertreter: **Loesenbeck, Karl-Otto, Dipl.-Ing. et al**
**Jöllenbecker Strasse 164**
**D-4800 Bielefeld 1(DE)**

(54) **Anreihbares Einbaugehäuse.**

(57) Bei diesem anreihbaren Einbaugehäuse ist in dem Deckelabschnitt (4) des den Einbauraum umschließenden Rahmenteiles (1) eine Durchtrittsöffnung (10) für eine mit einem Griffteil(11) versehene steckkartenartige Leiterplatte (12) vorgesehen, die in Führungsschlitzen (14) geführt und gehalten ist und die mit ihrem unteren Ende in einen im Bodenbereich des Einbaugehäuses angeordneten Steckverbinder (16): eingesteckt werden kann, so daß diese Leiterplatte (12) ohne Montagearbeiten am Einbaugehäuse im übrigen ausgewechselt werden kann.

## Anreihbares Einbaugehäuse

Die Erfindung betrifft ein anreihbares Einbaugehäuse mit einem äußeren, verschiedene Durchtrittsöffnungen aufweisenden Rahmenteil aus Isolierstoff, das einen Einbauraum umschließt, in dem elektrisch/elektronische Bauelemente, einschließlich Leiterplatten, auswechselbar und mit Anschlüssen für ankommende und abgehende Leiter verbindbar angeordnet sind.

Ein derartiges anreihbares Einbauteil ist beispielsweise aus der DE-PS 26 46 616 bekannt. Dort sind die Anschlüsse im Einbauraum lösbar und auswechselbar in Steckaufnahmen angeordnet. Es sind jedoch auch Einbaugehäuse bekannt (DE-PS 17 65 973), bei denen die Anschlüsse für die ankommenden und abgehenden Keiter fest mit dem Rahmenteil verbunden sind.

Bei den vorbekannten Einbaugehäusen sind nun die Aufnahmen für die Leiterplatten zwar so als Steck-oder Rastverbindungen ausgebildet, daß die Leiterplatten dem Grunde nach auswechselbar sind, doch werden bei den vorbekannten Ausgestaltungen die Leiterplatten von den offenen Seiten her in den von dem Rahmenteil umgebenden Einbauraum eingeführt, so daß im Falle einer erforderlichen Auswechslung das betroffene Einbaugehäuse aus der Anreihung derartiger Einbaugehäuse, beispielsweise auf einer Normtragschiene, herausmontiert werden muß, hierzu in vielen Fällen Leiteranschlüsse zu lösen sind und gegebenenfalls auch seitliche Abschlußplatten des Einbaugehäuses zu demontieren sind. Diese mühevolle Auswechslung ist besonders bei den Anwendungsfällen nachteilig, bei denen in dem Einbaugehäuse auch einige elektrisch/elektronische Bauelemente auf der oder den Leiterplatten vorzusehen sind, die als Verschleißteile oder als besonders empfindliche Teile ein relativ häufiges Auswechseln erfordern.

Der vorliegenden Erfindung liegt von daher die Aufgabe zugrunde, ein Einbaugehäuse der gattungsgemäßen Art zu schaffen, das ein besonders einfaches und schnelles Auswechseln defekter elektrisch/elektronischer Bauelemente ermöglicht.

Die erfindungsgemäße Lösung besteht darin, daß in dem Deckelabschnitt des Rahmenteils des Einbaugehäuses eine Durchtrittsöffnung für eine steckkartenförmige, mit einem Griffteil versehene Leiterplatte vorgesehen ist, das Einbaugehäuse Führungsschlitze für diese Leiterplatte aufweist und in seinem Bodenbereich eine Aufnahme für einen Steckverbinder für diese Leiterplatte vorgesehen ist.

Dank der Durchtrittsöffnung und der Führungsschlitze kann somit diese steckkartenförmige, mit dem Griffteil versehene Leiterplatte durch den Deckelabschnitt des Rahmenteiles des Einbaugehäuses hindurch zielgerecht zu dem im Bodenbereich des Einbaugehäuses vorgesehenen Steckverbinder geführt und hier in diesen eingesteckt werden, ohne daß dabei in irgendeiner Weise das Einbaugehäuse als solches aus einer Anreihung derartiger Einbaugehäuse herausgelöst werden müßte und ohne daß sonstige Demontagearbeiten oder das Lösen von Anschlüssen elektrischer Leiter erforderlich wären. Man kann somit besonders empfindliche elektrisch/elektronische Bauelemente und auch als Verschleißteile anzusehende elektrisch/elektronische Bauelemente auf eben dieser steckkartenförmigen. Leiterplatte zusammenfassen, um sie zusammen mit dieser besonders einfach und schnell auswechseln zu können.

Weitere bevorzugte Ausführungsformen sind in den Unteransprüchen gekennzeichnet.

Das Vorsehen der Führungsschlitze für die steckkartenförmige Leiterplatte im Deckelabschnitt sowie auch deren Verlängerung mittels Führungsleisten über einen Teil der Höhenerstreckung des Einbaugehäuses bewirken eine zielgerechte zuverlässige Führung der Leiterplatte hin zum Steckverbinder und gewährleisten darüber hinaus auch einen sicheren Halt der eingesteckten Leiterplatte.

Die Anordnung des Steckverbinders auf einer weiteren kleinen Leiterplatte und deren Einsteckung in den Bodenbereich des Einbaugehäuses, sowie ferner die Anformung der Führungsleisten für die steckkartenförmige Leiterplatte an gegebenenfalls, im Einbaugehäuse vorgesehenen Steckaufnahmen für die Anschlußteile tragen jeweils zum einfachen konstruktiven Aufbau eines derartigen Einbaugehäuses bei.

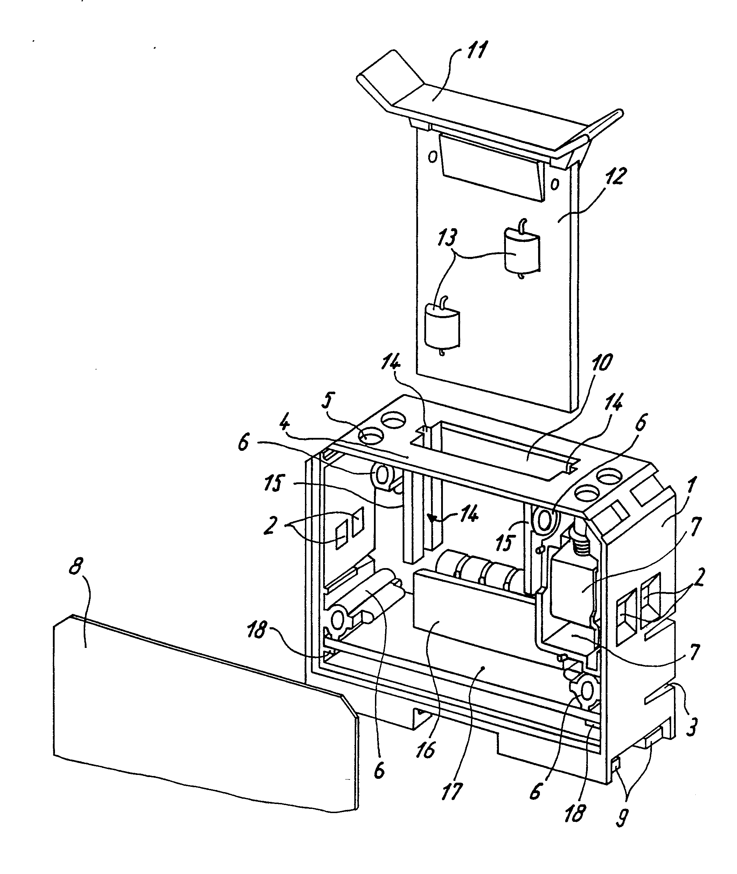

Ein bevorzugtes Ausführungsbeispiel eines anreihbaren Einbaugehäuses gemäß der Erfindung wird nachstehend unter Bezugnahme auf die Zeichnung näher beschrieben.

Die Zeichnung zeigt eine sprengbildliche Darstellung eines drartigen Einbaugehäuses in Perspektive.

Das in der Zeichnung dargestellte Einbaugehäuse hat ein äußeres Rahmenteil 1 aus Isolierstoff, das mit einer Mehrzahl unterschiedlicher Durchtrittsöffnungen versehen ist, beispielsweise mit in den seitlichen Rahmenteilen vorgesehenen Durchtrittsöffnungen 2 zum Hindurchstecken ankommender und abgehender elektrischer Leiter, mit sich seitlich öffnenden schlitzförmigen Durchtrittsöffnungen 3 beispielsweise für nach außen aus dem Einbaugehäuse vorstehende, den elektrisch /elektronischen Bauelementen direkt zugeordnete Anschlußteile wie Lötfahnen oder dergleichen. In dem oberen Deckelabschnitt 4 des Rahmenteiles 1 sind beispielsweise Durchtrittsöffnungen 5 für einen Schraubendreher vorgesehen, mit dem Schraubanschlüsse zur Festlegung der eingeführten elektrischen Leiter zu betätigen sind.

Im dargestellten Ausführungsbeispiel sind in dem von dem Rahmenteil 1 umschlossenen Einbauraum des Einbaugehäuses Steckaufnahmen 6 zum lösbaren Einfügen von gesonderten Anschlußteilen 7 vorgesehen, die die Anschlüsse für die ankommenden und abgehenden elektrischen Leitungen beinhalten. Im rechten Teil der Darstellung ist ein solches Anschlußteil 7 eingesteckt dargestellt.

Die offenen Seiten des Einbaugehäuses können durch anrastbare seitliche Verschlußplatten 8 verschlossen werden. Unter dem Boden des Rahmenteiles 1 befinden sich Steckaufnahmen 9, in die ein gesondertes Rastfußelement eingesteckt werden kann, mit dem dann das Einbaugehäuse auf einer Normtragschiene, in Anreihung mit zahlreichen derartigen weiteren Einbaugehäusen, aufgerastet werden kann.

In dem Deckelabschnitt 4 des Rahmenteiles 1 ist nun eine Durchtrittsöffnung 10 vorgesehen, die so dimensioniert ist, daß eine steckkartenförmige, mit einem Griffteil 11 versehene Leiterplatte 12, bestückt mit diversen elektrischen/elektronischen Bauelementen 13, hier von oben hindurchgesteckt werden kann. Die Anordnung ist dabei zweckmäßig so getroffen, daß in dem Deckelabschnitt 4 im Randbereich der Durchtrittsöffnung 10, einander gegenüberliegend, zwei Führungsschlitze 14 vorgesehen sind, in denen die Kantenbereiche der steckkartenförmigen Leiterplatte 12 geführt werden. In weiterer zweckmäßiger Ausgestaltung sind im Inneren des Einbaugehäuses sich über einen Teil seiner Höhe erstreckende Führungsleisten 15 vorgesehen, in denen sich die Führungsschlitze 14 verlängern. In zweckmäßiger Ausgestaltung sind dabei diese Führungsleisten 15 an die an gegebenem Ort vorgesehenen Steckaufnahmen 6 für die Anschlußteile 2 angeformt. Auf diese Weise erhält die steckkartenförmige Leiterplatte 2 eine zielgerechte Führung und einen sicheren Halt nach Einsteckung. Für die Festlegung des unteren Endes der steckkartenförmigen Leiterplatte 12 und für die Tätigung der elektrischen Kontaktierung ist im Bodenbereich des Einbaugehäuses ein Steckverbinder 16 vorgesehen, der zweckmäßig seinerseits auf einer kleinen Leiterplatte 17 angeordnet ist und mittels dieser in einer Aufnahme des Einbaugehäuses lösbar gehalten ist. Diese Aufnahme kann in zweckmäßiger Ausgestaltung einerseits von den dort vorhandenen Steckaufnahmen 6 für die Anschlußteile 2 und andererseits von abständig darunter befindlichen Schubleisten 18 gebildet werden.

**Ansprüche**

1. Anreihbares Einbaugehäuse mit einem äußeren, verschiedene Durchtrittsöffnungen (2, 3, 5) aufweisenden Rahmenteil (1) aus Isolierstoff, das einen Einbauraum umschließt, in dem elektrisch/elektronische Bauelemente, einschließlich Leiterplatten, auswechselbar und mit Anschlüssen (7) für ankommende und abgehende elektrische Leiter verbindbar angeordnet sind, **dadurch gekennzeichnet** sind, daß in dem Deckelabschnitt (4) des Rahmenteiles (1) eine Durchtrittsöffnung (10) für eine steckkartenförmige, mit einem Griffteil (11) versehene Leiterplatte (12) vorgesehen ist, das Einbaugehäuse Führungsschlitze (14) für diese Leiterplatte (12) aufweist und in seinem Bodenbereich ein Steckverbinder (16) für diese Leiterplatte (12) angeordnet ist.

2. Anreihbares Einbaugehäuse nach Anspruch 1, dadurch gekennzeichnet, daß der Steckverbinder (16) auf einer Leiterplatte (17) angeordnet ist, die lösbar in einer Steckaufnahme (6, 18) in dem Einbaugehäuse angeordnet ist.

3. Anreihbares Einbaugehäuse nach Anspruch 2, dadurch gekennzeichnet, daß die Steckaufnahme einerzeits von einem Teil der Steckaufnahme (6) für Anschlußteile (2) und andererseits von einer abständig dazu angeordneten Schubleiste (18) gebildet ist.

4. Anreihbares Einbaugehäuse nach Anspruch 1, dadurch gekennzeichnet, daß die Führungsschlitze (14) in dem Deckelabschnitt (4) in zwei einander gegenüberliegenden Randbereichen der Durchtrittsöffnung (10) für die Leiterplatte (12) vorgesehen sind.

5. Anreihbares Einbaugehäuse nach Anspruch 4, dadurch gekennzeichnet, daß die Führungsschlitze (14) sich in Führungsleisten (15) über einen Teil der Höhenerstreckung des Einbaugehäuses erstrecken.

6. Anreihbares Einbaugehäuse nach Anspruch 5, dadurch gekennzeichnet, daß die Führungsleisten (15) an Steckaufnahmen (6) für Anschlußteile (2) angeformt sind.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | FR-A-2 368 204 (WEIDMÜLLER) <br> * Figur; Seite 4, Zeilen 17-22 * | 1 | H 05 K 7/14 <br> H 01 R 9/26 |
| A | | 4 | |
| Y | US-A-3 573 558 (BABCOCK) <br> * Figur 5; Spalte 5, Zeilen 24-44 * | 1 | |
| A | DE-A-1 815 041 (D. GRAESSLIN FEINWERKTECHNIK) <br> * Seite 5, Zeilen 1-12 * | 2,3 | |
| A | DE-B-1 765 973 (WEIDMÜLLER) <br> * Spalte 1, Zeilen 52-63 * | 4 | |
| A | GB-A-2 015 264 (UNITED GAS LTD.) <br> * Seite 1, Zeilen 28-37 * | 1,4 | RECHERCHIERTE SACHGEBIETE (Int. Cl.4) <br><br> H 05 K <br> H 01 R |

Der vorliegende Recherchenbericht wurde für alle Patentansprüche erstellt.

| Recherchenort <br> DEN HAAG | Abschlußdatum der Recherche <br> 03-11-1986 | Prüfer <br> TOUSSAINT F.M.A. |
|---|---|---|